# EUROPÄISCHE PATENTSCHRIFT

(11) **EP 3 815 473 B1**
(45) Veröffentlichungstag und Bekanntmachung des Hinweises auf die Patenterteilung: **24.08.2022**
(21) Anmeldenummer: 19736323.7
(22) Anmeldetag: 25.06.2019
(51) Int. Cl.: H05H 1/00

(54) **SONDE ZUR MESSUNG VON PLASMAPARAMETERN MITTELS AKTIVER PLASMARESONANZSPEKTROSKOPIE**
PROBE FOR MEASURING PLASMA PARAMETERS BY MEANS OF ACTIVE PLASMA-RESONANCE SPECTROSCOPY
SONDE DE MESURE DE PARAMÈTRES PLASMATIQUES PAR SPECTROSCOPIE DE RÉSONANCE PLASMATIQUE ACTIVE

(30) Priorität: 26.06.2018 DE 102018115389
(43) Veröffentlichungstag der Anmeldung: 05.05.2021
(73) Patentinhaber: Ruhr-Universität Bochum, 44801 Bochum (DE)
(72) Erfinder: POHLE, Dennis, 44787 Bochum (DE); SCHULZ, Christian, 44791 Bochum (DE); ROLFES, Ilona, 44879 Bochum (DE)
(74) Vertreter: Michalski Hüttermann & Partner Patentanwälte mbB
(86) Internationale Anmeldenummer: PCT/EP2019/066914
(87) Internationale Veröffentlichungsnummer: WO 2020/002379

(56) Entgegenhaltungen:
- KR-B1- 101 456 542
- US-A1- 2002 047 543
- US-B2- 7 192 505
- SCHULZ CHRISTIAN ET AL: "The Planar Multipole Resonance Probe: Challenges and Prospects of a Planar Plasma Sensor", IEEE TRANSACTIONS ON INSTRUMENTATION AND MEASUREMENT, IEEE SERVICE CENTER, PISCATAWAY, NJ, US, Bd. 64, Nr. 4, 1. April 2015 (2015-04-01), Seiten 857-864, XP011574446, ISSN: 0018-9456, DOI: 10.1109/TIM.2014.2358111 [gefunden am 2015-03-06]
- POHLE DENNIS ET AL: "An advanced high-temperature stable multipole resonance probe for industry compatible plasma diagnostics", 2018 11TH GERMAN MICROWAVE CONFERENCE (GEMIC), IMA, 12. März 2018 (2018-03-12), Seiten 235-238, XP033345244, DOI: 10.23919/GEMIC.2018.8335073 [gefunden am 2018-04-10]

## Beschreibung

Die Erfindung betrifft eine Sonde zur Messung von Plasmaparametern mittels aktiver Plasma-Resonanzspektroskopie.

Plasmen, also gasförmige Gemische neutraler und geladener Bestandteile, kommen in vielen technischen Bereichen zum Einsatz. Zum Beispiel können sie eingesetzt werden, um Oberflächen zu modifizieren, für Reinigungs- oder Sterilisationsprozesse, oder indem Ablagerungsprozesse genutzt werden, um beispielsweise hochpräzise Beschichtungen für optische Anwendungen herzustellen. Dabei sind die speziellen Eigenschaften des Plasmas relevant für den technischen Einsatz. Über Plasmaparameter, wie die Elektronendichte, die Stoßfrequenz oder die Elektronentemperatur können Informationen über den Zustand des Plasmas ermittelt werden. Beispielsweise ist die Elektronentemperatur ein Maß für die Aktivität des Plasmas und die Stoßfrequenz liefert Information über die Neutralgaszusammensetzung. Wesentlich für den Erfolg eines Verfahrens, das auf der Verwendung von Plasmen basiert, ist häufig die genaue Kenntnis des Plasmazustandes. So kann der Prozess nicht nur überwacht sondern auch gesteuert werden, um optimale Ergebnisse zu erzielen. Die Bestimmung von Plasmaparametern ist also in vielen Fällen wesentlich für den Erfolg eines Verfahrens. Dementsprechend gibt es mehrere Methoden, um Plasmaparameter zu bestimmen. Allerdings sind nur wenige Methoden industriekompatibel. Damit eine Methode industriekompatibel ist, muss sie robust gegen Ablagerungen und Störungen sein, möglichst geringe Kosten aufweisen, einen Messprozess und eine Auswertung mit möglichst niedrigem Aufwand ermöglichen, den Plasmaprozess durch den Messprozess nicht beeinflussen und für eine Echtzeitauswertung geeignet sein.

Sonden zur Messung von Plasmaparametern mittels aktiver Plasma-Resonanzspektroskopie sind im Stand der Technik bekannt. In der Regel weisen die Sonden einen Sondenkopf auf, der die Form einer Kugel hat. Dieses Sondendesign hat Vorteile, die sich aus den mathematischen Überlegungen der Multipolentwicklung ergeben. Bei der Multipolentwicklung handelt es sich um eine Methode, die es beim Vorliegen der Voraussetzungen separabler Koordinaten erlaubt, die hinter dem Ersatzschaltbild stehenden mathematischen Zusammenhänge explizit aufzulösen, wodurch eine eindeutige Auswertevorschrift für die Bestimmung der Plasmaparameter erhalten wird.

Die DE 10 2006 014 106 B3 offenbart eine Vorrichtung zur Messung der Dichte eines Plasmas, bei welcher eine Resonanzfrequenz als Antwort auf ein in ein Plasma eingekoppeltes Hochfrequenzsignal bestimmt und zur Berechnung der Plasmadichte herangezogen wird. Die Vorrichtung umfasst eine in das Plasma einbringbare Sonde mit einem Sondenkopf in Form eines dreiachsigen Ellipsoids sowie Mittel zum Einkoppeln einer Hochfrequenz in den Sondenkopf durch einen den Sondenkopf haltenden Schaft.

Die DE 10 2010 055 799 B3 offenbart ebenfalls eine Vorrichtung zur Messung der Dichte eines Plasmas. Die Vorrichtung umfasst eine in das Plasma einbringbare Sonde mit einem Sondenkopf, der aus zwei halbkugelförmigen Elektrodenbereichen besteht, sowie Mittel zum Einkoppeln einer Hochfrequenz in den Sondenkopf durch einen den Sondenkopf haltenden Schaft. Der Sondenkopf weist einen Mantel und einen vom Mantel umgebenen Sondenkern auf. Die Sonde weist ein Symmetrierglied auf, welches im Übergang zwischen dem Sondenkopf und einer Hochfrequenzsignalzuführung wirksam ist.

Die Druckschrift Schulz Christiane et al: "The Planar Multipole Resonance Probe: Challenges and Prospects of a Planar Plasma Sensor" publiziert in IEEE Transactions on Instrumentation and Measurement, Bd 64, Nr. 4, 1. April 2015 (DOI: 10.1109/TIM.2014.2358111) beschreibt einen kompakten Plasmasensor, der für die Überwachung und Steuerung industrieller Plasmaprozesse geeignet ist. Basierend auf der Multipol-Resonanzsonde (MRP) wird eine planare MRP (pMRP) als leistungsstarkes und wirtschaftliches Monitoring-Tool bündig in die Reaktorwand eingebaut.

Die Druckschrift Pohle Dennis et al: "An advanced high-temperature stable multipole resonance probe for industry compatible plasma diagnostics" publiziert in 2018, 11th German Microwave conference (GEMIC), IMA, 12. März 2018, Seiten 235-238 XP033345244 (DOI: 10.23919/GEMIC.2018.8335073) beschreibt die Entwicklung eines fortschrittlichen, hochtemperaturstabilen Plasmasensors auf Basis der Multipol-Resonanzsonde (MRP). Die Verwendung von LTCC-Keramik (*Low Temperature Cofired Ceramics*) als Substratmaterial in Verbindung mit einem mehrschichtigen Aufbau bietet eine hohe Temperaturbeständigkeit sowie eine ausreichende mechanische Stabilität. Damit ist der Sensor als robustes Messwerkzeug in einem weiten Feld industrieller Plasmaprozesse einsetzbar.

Das Einführen einer Sonde der oben beschriebenen Art in den Plasmareaktor für einen Messvorgang bedeutet in der Regel eine Störung des Plasmas. Der Messvorgang führt zu einer Verformung des Plasmas und kann dazu führen, dass sich hinter der Sonde Ablagerungen bilden. Das oben beschriebene Sondendesign kann auch nicht beliebig verkleinert werden, denn bei einer Verkleinerung würde sich die Robustheit der Sonde verringern.

Davon ausgehend ist es die Aufgabe der Erfindung, eine Sonde zur Messung von Plasmaparametern bereitzustellen, die eine verbesserte Messung der Plasmaparameter ermöglicht, wobei bei der Messung der Plasmaparameter das Plasma insbesondere möglichst wenig beeinflusst werden soll.

Diese Aufgabe wird durch den Gegenstand des Patentanspruchs 1 gelöst. Bevorzugte Weiterbildungen finden sich in den Unteransprüchen.

Erfindungsgemäß ist also eine Sonde zur Messung von Plasmaparametern mittels aktiver Plasma-Resonanzspektroskopie angegeben, wobei die Sonde eine externe Ankopplung, ein Symmetrierglied, eine interne Ankopplung und einen Sondenkopf umfasst, wobei die Ankopplungen, das Symmetrierglied und der Sondenkopf in einem elektrisch isolierenden Substratzylinder integriert sind und der Substratzylinder entlang seiner Rotationsachse einen schichtartigen Aufbau aus mehreren Substratlagen aufweist.

Die erfindungsgemäße Sonde zur Messung von Plasmaparametern mittels aktiver Plasma-Resonanzspektroskopie weist durch ihren Aufbau eine verbesserte Form auf, ist besonders kompakt und robust und erlaubt eine industrielle Fertigung durch Standardprozesse. Die Grundidee der Erfindung liegt darin, die einzelnen Komponenten wie die Ankopplungen, das Symmetrierglied und den Sondenkopf in einem Bauteil, dem Substratzylinder, zu integrieren, wodurch die Sonde besonders robust wird. Durch den schichtartigen Aufbau des Substratzylinders gelingt eine raumsparende Integration der einzelnen Komponenten, wodurch die Sonde besonders kompakt wird. Die zylinderförmige Form des Substratzylinders führt dazu, dass die Sonde bündig in eine Reaktorwand eingebaut werden kann, so dass mit einem möglichst geringen Einfluss der Sonde auf das Plasma, die Plasmaparameter gemessen werden können.

Die aktive Plasma-Resonanzspektroskopie erlaubt die Messung von Plasmaparametern, wie die Elektronendichte, die Stoßfrequenz oder die Elektronentemperatur. Dadurch können Informationen über den Zustand des Plasmas ermittelt werden. Beispielsweise ist die Elektronentemperatur ein Maß für die Aktivität des Plasmas und die Stoßfrequenz liefert Information über die Neutralgaszusammensetzung.

Bei der aktiven Plasma-Resonanzspektroskopie wird ein Hochfrequenzsignal im Gigahertzbereich in das Plasma eingekoppelt. Die Signalreflexion wird als Funktion der Frequenz gemessen, unter anderem werden die Resonanzen als Maxima der Absorption, beziehungsweise als Minima des Eingangsreflexionsfaktors ermittelt. Die elektrische Einkopplung des Hochfrequenzsignals ist sehr anspruchsvoll, da der Sondenkopf symmetrisch mit dem Hochfrequenzsignal angesteuert werden muss. Die symmetrische Ansteuerung setzt grundsätzlich voraus, dass die Zuleitungen ebenfalls elektrisch symmetrisch ausgebildet sein müssen, so dass sich durch die Leitungsführung keine Phasenverschiebung ergibt. Allerdings ist die Umsetzung einer solchen Leitungsführung sehr aufwändig. Das Symmetrierglied, auch Balun genannt, ist ein Bauteil zur Wandlung zwischen einem symmetrischen Leitungssystem und einem unsymmetrischen Leitungssystem. Das Symmetrierglied arbeitet in beide Richtungen und ermöglicht die Verwendung unsymmetrischer Leitungszuführungen.

Der Substratzylinder hat die Form eines senkrechten Kreiszylinders. Die Höhe des Substratzylinders liegt bevorzugt zwischen 3,5 und 4 mm. Der Durchmesser des Substratzylinders liegt bevorzugt zwischen 33 und 34 mm.

Gemäß einer bevorzugten Weiterbildung der Erfindung sind die externe Ankopplung, das Symmetrierglied, die interne Ankopplung und der Sondenkopf entlang der Rotationsachse des Substratzylinders in der genannten Reihenfolge in unterschiedlichen Substratlagen angeordnet. Die Anordnung des Sondenkopfes nahe bei der Oberfläche des Substratzylinders ist für eine erfolgreiche Messung der Plasmaparameter wichtig, da durch diese Ausführung bei der Messung der Sondenkopf in räumlicher Nähe zum Plasma zu liegen kommt. Da das Symmetrierglied es ermöglicht den Sondenkopf symmetrisch mit dem Hochfrequenzsignal anzusteuern, ist es von Vorteil, wenn das Symmetrierglied möglichst direkt vor dem Sondenkopf angeordnet ist, also nur die interne Ankopplung zwischen dem Sondenkopf und dem Symmetrierglied liegt. Um Hochfrequenz in die Sonde einzukoppeln, befindet sich die externe Ankopplung vor dem Symmetrierglied. Dementsprechend ist ein gestapelter Aufbau der Komponenten im Substratzylinder räumlich vorteilhaft. Der Aufbau lässt sich besonders einfach umsetzten, wenn die einzelnen Komponenten in unterschiedlichen Substratlagen angeordnet sind. Zudem hat dies den Vorteil, dass der elektrisch isolierende Substratzylinder eine ungewollte Kontaktierung zwischen den Komponenten verhindert.

Gemäß einer bevorzugten Weiterbildung der Erfindung umfasst der Sondenkopf zwei gegeneinander isolierte metallische Halbscheiben und ist durch mindestens eine Substratlage von der Oberfläche des Substratzylinders getrennt. Die metallischen Halbscheiben des Sondenkopfes sind Elektroden. Sie weisen während der Messung eine gegensätzliche elektrische Polarität auf, so dass sich ein elektrisches Feld aufbauen kann. Dazu müssen sie voneinander elektrisch isoliert sein. Um bei der Messung keinen direkten Kontakt mit dem Plasma zu haben, sind die metallischen Halbscheiben von mindestens einer Substratschicht von der Oberfläche des Substratzylinders getrennt. Besonders bevorzugt sind die metallischen Halbscheiben von genau einer Substratschicht von der Oberfläche des Substratzylinders getrennt. So sind die metallischen Halbscheiben vor dem Plasma geschützt und gleichzeitig ist die räumliche Entfernung der metallischen Halbscheiben zum Plasma gering. Die metallischen Halbscheiben weisen einen Durchmesser von bevorzugt 3 bis 5 mm auf. Der Durchmesser der metallischen Halbscheiben kann abhängig vom Einsatzbereich der Sonde unterschiedlich sein. Ein Sondenkopf mit metallischen Halbscheiben mit großem Durchmesser wird bevorzugt für die Überwachung von Plasmen mit geringer Elektronendichte und niedrigen Resonanzfrequenzen eingesetzt. Ein Sondenkopf mit metallischen Halbscheiben mit geringem Durchmesser wird bevorzugt für die Überwachung von Plasmen mit hoher Elektronendichte und hohen Resonanzfrequenzen eingesetzt.

Gemäß einer bevorzugten Weiterbildung der Erfindung weist die Sonde zwischen dem Sondenkopf und dem Symmetrierglied mindestens eine Substratlage auf, wobei der Sondenkopf und das Symmetrierglied über die interne Ankopplung miteinander kontaktiert sind. Durch die Integration der einzelnen Komponenten im Substratzylinder muss darauf geachtet werden, dass die Messung nicht durch überkoppelnde Felder beeinflusst wird. Um den Sondenkopf vor einem überkoppelnden Feld des Symmetriergliedes abzuschirmen und das Symmetrierglied vor einem überkoppelnden Feld des Sondenkopfes abzuschirmen, weist die Sonde zwischen dem Sondenkopf und dem Symmetrierglied mindestens eine Substratlage auf. Bevorzugt weist die Sonde zwischen dem Sondenkopf und dem Symmetrierglied 7 oder 13 Substratlagen auf. Dies führt zu einer besonders guten Abschirmung und ermöglicht trotzdem einen kompakten Aufbau der Sonde. Um zwischen dem Sondenkopf und dem Symmetrierglied eine elektrische Verbindung herzustellen, sind der Sondenkopf und das Symmetrierglied über die interne Ankopplung miteinander kontaktiert.

Um ein möglichst einfaches Einkoppeln von Hochfrequenz in die Sonde zu ermöglichen, umfasst die Sonde gemäß einer bevorzugten Weiterbildung der Erfindung einen Stecker, wobei der Stecker und das Symmetrierglied über die externe Ankopplung miteinander kontaktiert sind. Der Stecker ist bevorzug ein Stecker, um eine Hochfrequenzleitung anzuschließen. Besonders bevorzugt handelt es sich um einen Stecker für ein Koaxialkabel. Ein Koaxialkabel ist eine elektrische Hochfrequenzsignalführung und in der Regel geschirmt. Deswegen strahlt das Koaxialkabel im Wesentlichen weder Energie ab noch nimmt es welche auf, und verursacht deswegen praktisch keine Störungen. Der Stecker befindet sich an der Oberfläche der Sonde und ist über die externe Ankopplung mit dem Symmetrierglied elektrisch kontaktiert. Der Leitungswellenwiderstand des Steckers, der externen Ankopplung und des Symmetriergliedes sind so ausgelegt, dass sie an den Leitungswellenwiderstand des vorgeschalteten Koaxialkabels angepasst sind. Beispielsweise beträgt der Leitungswellenwiderstand für die genannten Komponenten 50 Ohm und der Leitungswellenwiderstand des vorgeschalteten Koaxialkabels ebenfalls 50 Ohm.

Gemäß einer bevorzugten Weiterbildung der Erfindung umfasst das Symmetrierglied zwei zueinander parallel verlaufende Leiterbahnen, wobei jeweils ein Ende der Leiterbahn mit der externen Ankopplung verbunden ist und das andere Ende der Leiterbahn mit der internen Ankopplung, die Leiterbahnen durch mindestens eine Substratlage voneinander getrennt sind, die erste Leiterbahn eine Masse-Lage ist, die zweite Leiterbahn eine Signal-Lage ist, die erste Leiterbahn eine sich verändernde Breite aufweist und die Leiterbahnen bezogen auf die Richtung der Rotationsachse des Substratzylinders übereinander zu liegen kommen. Die zwei Leiterbahnen des Symmetriergliedes sind zwecks elektrischer Kontaktierung an ihren Enden jeweils mit den Ankopplungen verbunden. Die Leiterbahnen verlaufen zueinander parallel und sind durch mindestens eine Substratlage voneinander getrennt. Bevorzugt sind sie durch zwei Substratlagen voneinander getrennt, um eine gute elektrische Isolierung voneinander zu erreichen. Die erste Leiterbahn, die eine Masse-Lage ist, weist eine sich verändernde Breite auf. Bevorzugt ist die Breite der ersten Leiterbahn nahe bei der externen Ankopplung groß. Weiter bevorzugt nimmt die Breite der ersten Leiterbahn dann entlang der Leiterbahn in Richtung Sondenkopf ab, so dass sich eine trapezförmige Geometrie der ersten Leiterbahn ergibt. Grundsätzlich ist es möglich, dass die zweite Leiterbahn eine nahezu unveränderte Breite aufweist. Bevorzugt weist aber auch die zweite Leiterbahn eine sich verändernde Breite auf. Bezogen auf die Richtung der Rotationsachse des Substratzylinders liegen die zwei Leiterbahnen übereinander, um eine kompakte Bauweise zu ermöglichen.

Gemäß einer bevorzugten Weiterbildung der Erfindung ist das Symmetrierglied ein gebogener Balun, der mindestens drei, bevorzugt vier unterschiedlich lange Abschnitte umfasst, wobei die Abschnitte miteinander in etwa rechtwinklig verbunden sind, so dass die Abschnitte die Form einer Spirale bilden, und die Ecken der Spirale abgeschrägt sind. Die Form des gebogenen Baluns bietet den Vorteil, dass drei der vier Abschnitte des Baluns räumlich vom Sondenkopf weit entfernt sind und somit die Kopplung mit dem Sondenkopf verringert wird. Des Weiteren wird der Platz besonders gut genutzt, wodurch sich eine kompakte Sonde realisieren lässt. Das Abschrägen der Ecken der Spirale, im Englischen als "mitered bends" bezeichnet, führt dazu, dass die durch die nahezu rechtwinklige Biegung verursachte zusätzliche Kapazität des Baluns kompensiert wird, so dass die Leitungsimpedanz, verglichen zu einem nicht gebogenen Balun, unverändert bleibt. Durch diesen Aufbau verhält sich der gebogene Balun nahezu identisch zu einem ungebogenen Balun mit ansonsten gleichen Parametern.

Alternativ ist das Symmetrierglied vorzugsweise ein gestapelt gefalteter Balun, der zwei zueinander parallel verlaufende Abschnitte umfasst, wobei die beiden Abschnitte durch mindestens eine Substratlage voneinander getrennt sind und durch eine parallel zur Rotationsachse des Substratzylinders verlaufende weitere Ankopplung miteinander kontaktiert sind. Alternativ zum Einsatz eines gebogenen Baluns lässt sich auch ein gestapelt gefalteter Balun einsetzten, der auf Englisch als "stacked folded balun" bezeichnet wird. Diese Art des Symmetrierglieds hat den Vorteil, dass der Aufbau symmetrisch ist und deswegen der Designprozess der Sonde wesentlich beschleunigt wird. Allerdings führt diese Form zu einer zusätzlichen Koppelung der übereinanderliegenden Abschnitte des Baluns. Deswegen befindet sich zwischen den beiden Abschnitten mindestens eine Substratlage. Bevorzugt befinden sich zwischen den beiden Abschnitten acht Substratlagen, um eine möglichst gute Abschirmung zu erreichen und gleichzeitig einen kompakten Aufbau zu ermöglichen. Die beiden Abschnitte sind durch eine weitere Ankopplung miteinander elektrisch kontaktiert, welche parallel zur Rotationsachse des Substratzylinders verläuft.

Gemäß einer bevorzugten Weiterbildung der Erfindung sind die Ankopplungen Durchkontaktierungen, die eine elektrische Verbindung durch die Substratlagen hindurch ermöglichen. Um die einzelnen Komponenten, die sich in unterschiedlichen Substratlagen befinden, miteinander elektrisch zu kontaktieren, sind die Ankopplungen als Durchkontaktierungen ausgestaltet. Durchkontaktierungen, im Englischen als "vias" bezeichnet, ermöglichen eine vertikale Verbindung durch die elektrisch isolierenden Substratlagen hindurch. Es können unterschiedliche Arten von Durchkontaktierungen verwendet werden. Die Durchkontaktierung kann beispielsweise nur durch eine Substratlage hindurch reichen. Für den Fall, dass diese Substratlage eine äußere Substratlage ist, bezeichnet man eine solche Durchkontaktierung als "blind via". Für den Fall, dass diese Substratlage von anderen Substratlagen eingeschlossen ist, bezeichnet man eine solche Durchkontaktierung als "buried via". Alternativ kann die Durchkontaktierung so ausgestaltet sein, dass zwei äußere Substratlagen miteinander verbunden werden, was als "through hole via" bezeichnet wird. Es kann von Vorteil sein mehrere Durchkontaktierungen mit versetzter Anordnung in jeder Substratlage vorzusehen, da so eine Fehl- oder Nichtkontaktierung im Rahmen der Fertigung weitestgehend ausgeschlossen werden kann.

Gemäß einer bevorzugten Weiterbildung der Erfindung ist der Substratzylinder aus mindestens einem Substratmaterial, bevorzugt aus einer LTCC-Keramik, hergestellt, wobei das Substratmaterial einen mehrlagigen Aufbau zulässt. Als Substratmaterial für den Substratzylinder wird bevorzugt eine Standard-Leiterplattentechnologie eingesetzt. Dabei soll das eingesetzte Substratmaterial einen mehrlagigen Aufbau, auch multi-layer-Aufbau genannt, ermöglichen, bei dem mehrere Substratlagen übereinander verwendet werden können, ohne dass es zu einem ungewollten elektrischen Kontakt zwischen den Leitern kommt. Auf die einzelnen, elektrisch isolierenden Substratlagen werden erst die leitenden Verbindungen aufgebracht und anschließend werden mehrere so strukturierte Substratlagen übereinander gelegt und miteinander, beispielsweise durch Druck oder Temperatur, verbunden, so dass ein nicht mehr separierbares Einzelstück entsteht. Als geeignete Substratmaterialien haben sich in Epoxidharz getränkte Glasfasermatten (beispielsweise FR-4) erwiesen und insbesondere das für die Hochfrequenztechnik geeignete Substratmaterial Ro4003. Besonders bevorzugt ist das Substratmaterial aus einem Material, das in der LTCC-Technologie eingesetzt werden kann. LTCC (low temperature cofired ceramics, Niedertemperatur-Einbrand-Keramiken) ist eine Technologie zur Herstellung von Mehrlagenschaltungen, also ein Substratmaterial, das einen mehrlagigen Aufbau zulässt, auf der Basis von gesinterten Keramikträgern. Die eingesetzten keramischen Substratmaterialien zeichnen sich durch eine hohe Temperaturstabilität aus. Die Verwendung von LTCC-Keramiken führt zu einem besonders temperaturstabilen Substratzylinder, der auch für Messungen in Plasmen über 200 °C eingesetzt werden kann. Besonders geeignet für die Herstellung des Substratzylinders sind beispielsweise die Substratmaterialien Du-Pont 951 oder Ferro A6M. Die Verwendung einer Standard-Leiterplattentechnologie hat den Vorteil, dass eine kostengünstige, reproduzierbare und industrietaugliche Realisierung mit hoher Fertigungsgenauigkeit möglich ist.

Grundsätzlich kann die äußerste Substratlage des Substratzylinders aus dem gleichen Substratmaterial sein, wie die anderen Substratlagen. Dies ermöglicht eine einfache Herstellung der Sonde. Gemäß einer bevorzugten Weiterbildung der Erfindung besteht die äußerste Substratlage auf der Seite des Substratzylinders, die sich näher beim Sondenkopf befindet, jedoch aus einem anderen Substratmaterial als die anderen Substratlagen. Die Substratlage auf der Seite des Substratzylinders, die sich näher beim Sondenkopf befindet, ist jene Substratlage, die bei einer Messung mit dem Plasma in Kontakt kommt. Deswegen kann es vorteilhaft sein, dass diese Substratlage aus einem anderen Substratmaterial besteht. Beispielsweise kann diese Substratlage aus Glas sein. Die äußerste Substratlage auf der Seite des Substratzylinders, die sich näher beim Sondenkopf befindet, kann auch eine andere Dicke aufweisen als die anderen Substratlagen. Somit kann diese Substratlage den Bedürfnissen der Messung angepasst werden.

Gemäß einer bevorzugten Weiterbildung der Erfindung ist der Substratzylinder in einen Hohlzylinder aus Metall eingefasst und die Seite des Substratzylinders, die sich näher beim Sondenkopf befindet, schließt plan mit der Oberkante des Hohlzylinders ab. Der Substratzylinder kann beispielsweise mit Kleber oder Lot in den Hohlzylinder eingefasst sein. Der Innendurchmesser des Hohlzylinders ist so groß, dass der Substratzylinder bündig in den Hohlzylinder eingefasst werden kann. Dabei kann es von Vorteil sein, wenn die Innenseite des Hohlzylinders einen Versatz aufweist, wobei der Substratzylinder auf der Versatzkante dieses Versatzes aufliegt. Bevorzugt ist der Innendurchmesser des Hohlzylinders 33 bis 34 mm ohne Versatz und 32 bis 33 mm mit Versatz. Es ergibt sich eine Versatzkante auf dem der Substratzylinder aufliegt von bevorzugt 1 mm. Die Wanddicke des Hohlzylinders liegt bevorzugt zwischen 2 und 3 mm. Besonders bevorzugt ist der Außendurchmesser des Hohlzylinders so ausgelegt, dass die Sonde in einen Standardflansch, beispielsweise in einen KF40-Flansch, eingepasst werden kann. Dies ermöglicht die Sonde in der Reaktorwand unterzubringen, so dass das Plasma durch den Messvorgang möglichst wenig beeinflusst wird. Der Hohlzylinder aus Metall hat eine Höhe zwischen 30 und 40 mm. Da der Substratzylinder auf der Seite des Sondenkopfes plan mit der Oberkante des Hohlzylinders abschließt und die Höhe des Hohlzylinders größer ist als die Höhe des Substratzylinders, steht der Hohlzylinder auf der Seite der externen Ankopplung über. Dies ermöglicht es, dass der Anschluss an die Sonde, der beispielsweise mit einem Stecker ausgeführt ist, durch den Hohlzylinder geschützt ist. Der Anschluss muss also keine hohe Temperaturstabilität aufweisen, da der Anschluss durch seine Lage innerhalb des Hohlzylinders bei der Messung sich nicht innerhalb der Reaktorkammer befindet. Das Einfassen des Substratzylinders in den Hohlzylinder aus Metall führt also dazu, dass die Reaktorkammer durch Einbringen der Sonde bereits am Flansch abgedichtet werden kann. So kann auf eine zusätzliche Vakuumdurchführung für beispielsweise ein Kabel das, an den Anschluss der Sonde angebracht wird, verzichtet werden.

Weiter oben heißt es, dass der Sondenkopf gemäß einer bevorzugten Weiterbildung der Erfindung zwei gegeneinander isolierte metallische Halbscheiben umfasst. Gemäß einer bevorzugten Ausgestaltung sind diese Halbscheiben plan. Alternativ können diese Halbscheiben gekrümmt ausgebildet sein, vorzugsweise mit einer Krümmung auf einer Zylinder- oder Kugeloberfläche. Dabei können die Halbscheiben einerseits auf einem steifen gekrümmten Substrat oder auf einem flexiblen, biegbaren Substrat aufgebracht sein. Auf diese Weise kann der Sensor an einen bestimmten Krümmungsradius des Zielsubstrats im Vorhinein angepasst werden bzw. flexibel für verschiedene Radien nachjustiert werden. In beiden Fällen kann der gekrümmte Sondenkopf als konforme Antenne betrachtet werden. Ein flexibler gebogener Sensor hat den Vorteil, dass er noch nach der Herstellung an jede beliebige zylindrische oder sphärische Zielform mit quasi beliebigem Krümmungsradius angepasst werden kann. So ist dieselbe Sonde zum Beispiel für verschiedene Flaschengrößen anwendbar. Aufgrund dieser Formanpassungsfähigkeit ist der flexible Sensor außerdem für planare Substrate geeignet. Im Falle eines starren Designs kann ein gekrümmter Substrathalter mittels 3D-Druck oder CNC-Fräsen hergestellt werden. Die metallischen Halbscheiben werden im Anschluss entweder direkt auf dem Substrathalter aufgebracht, z. B. durch eine aufgesprühte metallische Beschichtung (z. B. Silberlack), oder sie werden auf einem biegsamen HF-Substrat, das auf den Substrathalter geklebt wird, mittels Standardverfahren aufgedruckt. Ein zusätzlicher metallischer Adapterring kann sich direkt hinter dem Sondenkopfsubstrat befinden und zur Impedanzanpassung verwendet werden. Ein metallischer Zylinder kann als Halterung und Positionierung für den Sondenkopf dienen und durch einen Flansch des Reaktors eingeführt werden. Sowohl Adapterring als auch Zylinder können auf Seiten des Sondenkopfes den gleichen Krümmungsradius wie dieser aufweisen, so dass alles bündig miteinander abschließt. Im Falle eines flexiblen Designs können die metallischen Halbscheiben unter Verwendung von Standardtechniken auf ein biegsames HF-Substrat gedruckt werden. Im Anschluss wird das Sondenkopfsubstrat auf einen flexiblen Adapterring aufgeklebt, der aus einem Schaumstoffmaterial besteht und dessen Oberfläche metallisch beschichtet wurde und/oder das Material selbst metallische bzw. leitfähige Einschlüsse aufweist. Durch diese Flexibilität der Formanpassung wird erreicht, dass sich der Sondenkopf der Form des Zielsubstrats anpassen kann. Ein einfacher hohler Metallzylinder mit Auflagerand kann als Halter für den Schaumstoffadapterring verwendet werden.

Nachfolgend wird die Erfindung unter Bezugnahme auf die Zeichnung anhand eines bevorzugen Ausführungsbeispiels exemplarisch erläutert.

In der Zeichnung zeigen
- Fig. 1: eine schematische Darstellung einer Sonde, gemäß einem bevorzugten Ausführungsbeispiel der Erfindung,
- Fig. 2: eine perspektivische Darstellung eines Substratzylinders, gemäß einem bevorzugten Ausführungsbeispiel der Erfindung,
- Fig. 3: eine schematische Darstellung eines Symmetriergliedes in einer ersten Ausführungsform, zusammen mit dem Substratzylinder, einem Sondenkopf und einem Stecker,
- Fig. 4: eine perspektivische Darstellung des Symmetriergliedes in einer ersten Ausführungsform,
- Fig. 5: eine perspektivische Darstellung einer Ankopplung des Sondenkopfes an das Symmetrierglied in einer ersten Ausführungsform,
- Fig. 6: schematische und perspektivische Darstellungen einer Ankopplung des Steckers an das Symmetrierglied in einer ersten Ausführungsform,
- Fig. 7: eine schematische Darstellung eines Symmetriergliedes in einer zweiten Ausführungsform, zusammen mit dem Sondenkopf und dem Stecker,
- Fig. 8: eine perspektivische Darstellung des Symmetriergliedes in einer zweiten Ausführungsform, zusammen mit dem Sondenkopf und dem Stecker,
- Fig. 9: eine schematische Darstellung des Symmetriergliedes in einer zweiten Ausführungsform, zusammen mit dem Substratzylinder und dem Stecker,
- Fig. 10: schematische und perspektivische Darstellungen der Ankopplung des Steckers an das Symmetrierglied in einer zweiten Ausführungsform,
- Fig. 11: eine schematische Darstellung einer Durchkontaktierung, gemäß einem bevorzugten Ausführungsbeispiel,
- Fig. 12: eine perspektivische und eine schematische Darstellung eines Hohlzylinders, gemäß einem bevorzugten Ausführungsbeispiel und
- Fig. 13: zwei perspektivische Darstellungen der Sonde, gemäß einem bevorzugten Ausführungsbeispiel.

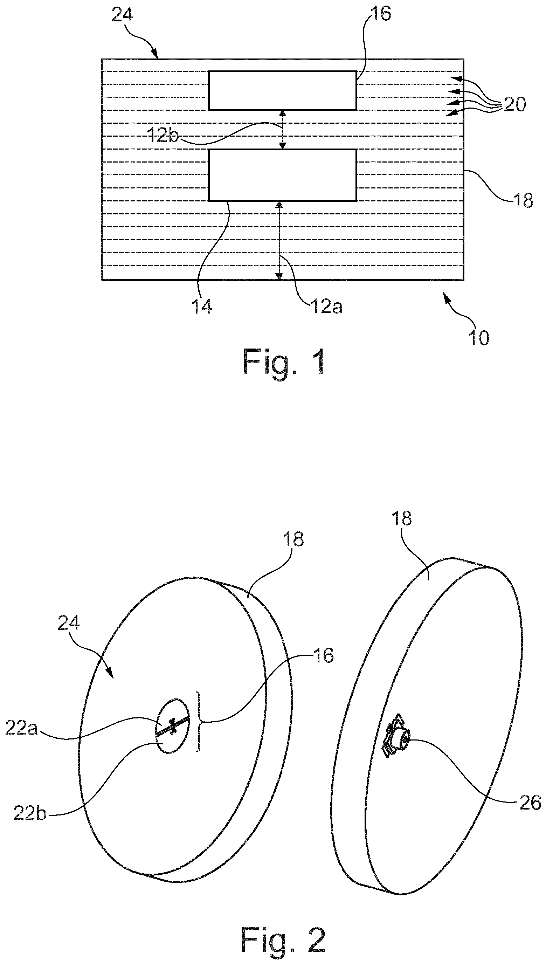

Fig. 1 zeigt schematischen den Aufbau einer Sonde 10. Innerhalb eines Substratzylinders 18 befindet sich eine externe Ankopplung 12a, ein Symmetrierglied 14, eine interne Ankopplung 12b, sowie ein Sondenkopf 16. Der Substratzylinder 18 weist entlang seiner Rotationsachse einen schichtartigen Aufbau aus mehreren Substratlagen 20 auf. Der Sondenkopf ist im hier bevorzugten Ausführungsbeispiel durch eine Substratschicht 20 von einer Oberfläche 24 des Substratzylinders getrennt.

Fig. 2 zeigt zwei perspektivische Darstellungen des Substratzylinders 18, wobei in Fig. 2a die Seite des Substratzylinders mit dem Sondenkopf 16 sichtbar ist, und in Fig. 2b die gegenüberliegende Seite mit einem Stecker 26. Der Sondenkopf 16 umfasst zwei metallische Halbscheiben 22a und 22b. Auf der dem Sondenkopf gegenüberliegenden Seite, weist der Substratzylinder den Stecker 26, zum Anschluss der Sonden an ein Koaxialkabel auf.

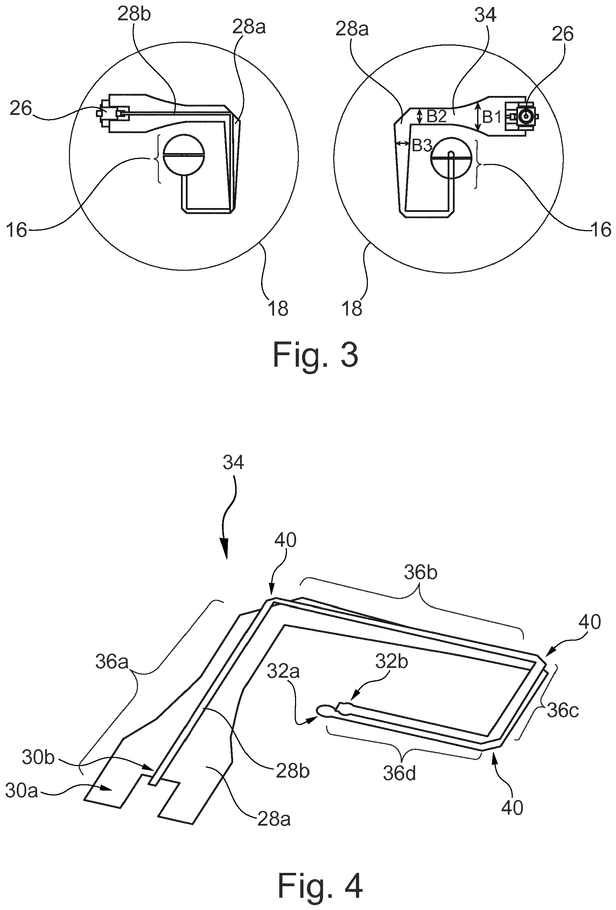

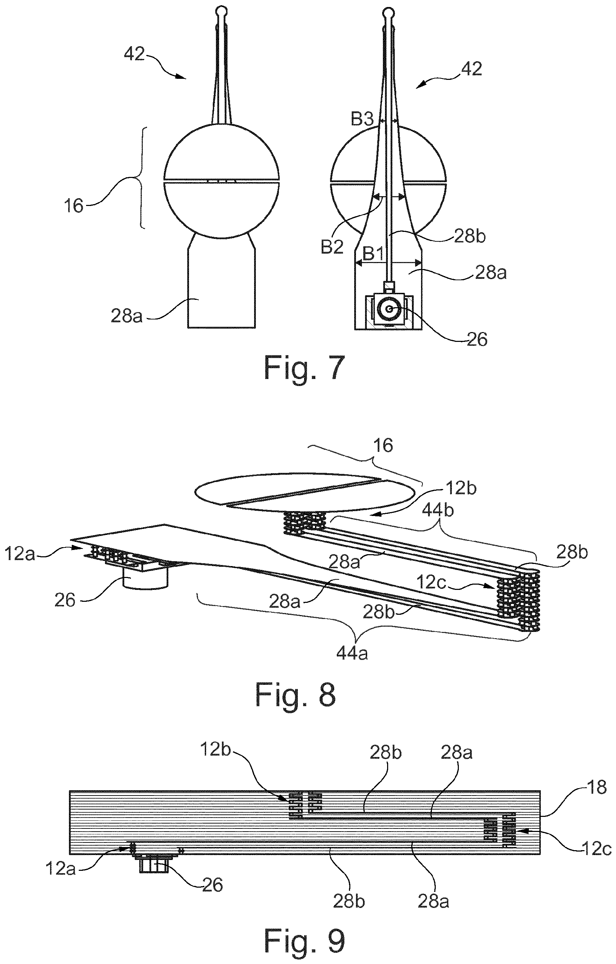

Für das Symmetrierglied 14 sind zwei Ausführungsformen möglich. Je nach Ausführungsform des Symmetriergliedes 14 ist die Gestaltung der externen Ankopplung 12a an das Symmetrierglied 14 und die Gestaltung der internen Ankopplung 12b an den Sondenkopf 16 anzupassen. Figuren 3, 4, 5 und 6 beziehen sich auf die erste Ausführungsform, Figuren 7, 8, 9 und 10 auf die zweite Ausführungsform.

Fig. 3 und 4 zeigen das Symmetrierglied 14 in einer ersten Ausführungsform, als gebogener Balun 34. In Fig. 3 sind zusätzlich noch der Substratzylinder 18, der Stecker 26 und der Sondenkopf 16 abgebildet. Der gebogene Balun 34 weist zwei Leiterbahnen 28a und 28b auf, wobei die erste Leiterbahn 28a eine sich verändernde Breite B1 B2 B3 aufweist. Die Leiterbahnen 28a, 28b sind mit ihrem jeweiligen einen Ende 30a, 30b über die externe Ankopplung 12a mit dem Stecker 26 kontaktiert und mit den jeweiligen anderen Enden 32a, 32b über die interne Ankopplung 12b mit dem Sondenkopf 16. Der gebogene Balun 34 umfasst vier Abschnitte 36a, 36b, 36c, 36d, die so miteinander verbunden sind, dass sie die Form einer Spirale 38 bilden. Ecken 40 der Spirale 38 sind abgeschrägt.

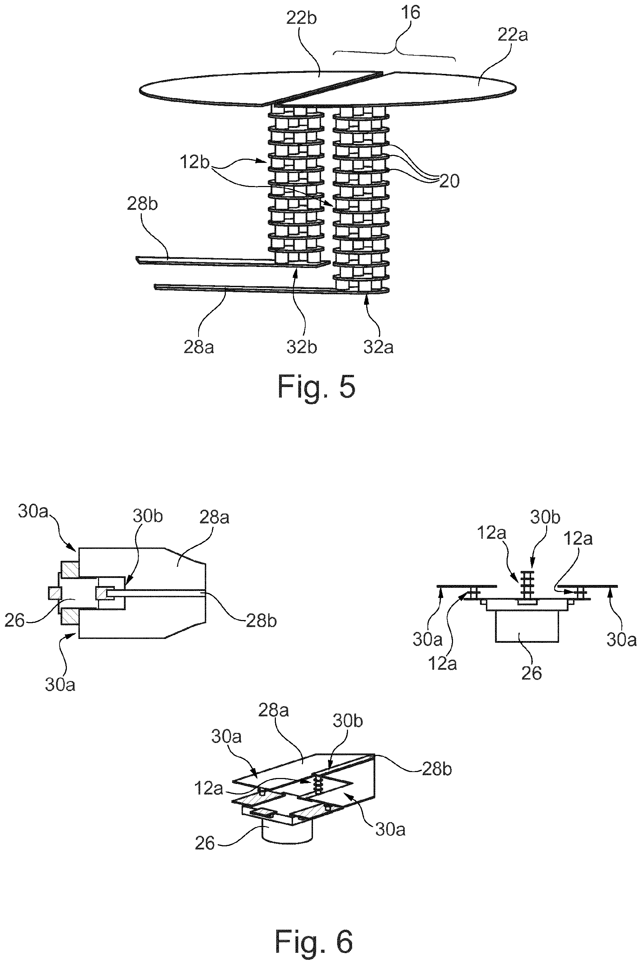

Die Ankopplung des Symmetriergliedes 14 in der ersten Ausführungsform als gebogener Balun 34 an den Sondenkopf 16 ist in Fig. 5 dargestellt. Fig. 5 zeigt eine perspektivische Darstellung des Sondenkopfes 16 mit der internen Ankopplung 12b an das Symmetrierglied 14, wobei das Symmetrierglied 14 nicht vollständig abgebildet ist Der Sondenkopf 16 ist hier 13 Substratlagen 20 vom Symmetrierglied 14 entfernt und über die interne Ankopplung 12b mit ihm kontaktiert. Das Symmetrierglied 14 umfasst eine erste Leiterbahn 28a, welche mit ihrem Ende 32a über die interne Ankopplung 12b mit der metallischen Halbscheibe 22a des Sondenkopfes 16 kontaktiert ist. Die zweite Leiterbahn 28b des Symmetriergliedes 14 ist mit ihrem Ende 32b über die interne Ankopplung 12b mit der zweiten Halbscheibe 22b des Sondenkopfes kontaktiert. Die zwei Leiterbahnen 28a und 28b sind zwei Substratlagen 20 voneinander entfernt.

Fig. 6 zeigt drei perspektivische Darstellungen des Steckers 26, der externen Ankopplung 12a und des Symmetriergliedes 14 in der ersten Ausführungsform, wobei das Symmetrierglied 14 nicht vollständig abgebildet ist. Das Symmetrierglied 14 in der ersten Ausführungsform weist zwei Leiterbahnen 28a und 28b auf, die mit ihrem jeweiligen Ende 30a und 30b über die externe Ankopplung 12a mit dem Stecker 26 kontaktiert sind. Die erste Leiterbahn 28a ist zwei Substratlagen 20 vom Stecker 26 entfernt. Sie weist an ihrem Ende 30a eine Aussparung auf, so dass das Ende 30a der ersten Leiterbahn 28a u-förmig gestaltetet ist. Zwei Arme der U-Form sind über die externe Ankopplung 12a mit dem Stecker 26 kontaktiert. Die zweite Leiterbahn 28b des Symmetriergliedes 14 ist vier Substratlagen vom Stecker 26 entfernt. Ihr Ende 30b kommt mittig über die Aussparung der ersten Leiterbahn 28a zu liegen und ist über die externe Ankopplung 12a mit dem Stecker 26 kontaktiert. Die erste und zweite Leiterbahn 28a und 28b sind zwei Substratlagen 20 voneinander entfernt.

In Fig. 7, Fig. 8 und Fig. 9 ist das Symmetrierglied 14 in der zweiten Ausführungsform, als gestapelt gefalteter Balun 42 dargestellt. Zusätzlich sind in Fig. 7 und Fig. 8 noch der Stecker 26 und der Sondenkopf 16 abgebildet und in Fig. 9 der Substratzylinder 18. Der gestapelt gefaltete Balun 42 weist zwei Leiterbahnen 28a und 28b auf, wobei die erste Leiterbahn 28a eine sich verändernde Breite B1 B2 B3 aufweist. Die Leiterbahnen 28a, 28b sind mit ihrem jeweiligen einen Ende 30a, 30b über die externe Ankopplung 12a mit dem Stecker 26 kontaktiert und mit den jeweiligen anderen Enden 32a, 32b über die interne Ankopplung 12b mit dem Sondenkopf 16. Der gestapelt gefaltete Balun 42 umfasst zwei Abschnitte 44a, 44b, die über eine interne Ankopplung 12c miteinander kontaktiert sind. Zwischen der ersten Leiterbahn 28a des ersten Abschnittes 44a und der ersten Leiterbahn 28a des zweiten Abschnittes 44b befinden sich acht Substratlagen. Zwischen der zweiten Leiterbahn 28b des ersten Abschnittes 44a und der zweiten Leiterbahn 28b des zweiten Abschnittes 44b befinden sich zwölf Substratlagen. Die erste und zweite Leiterbahn 28a und 28b sind durch zwei Substratlagen 20 voneinander getrennt. Der Sondenkopf ist neun Substratlagen 20 von der ersten Leiterbahn 28a des zweiten Abschnittes 44b und sieben Substratlagen 20 von der zweiten Leiterbahn 28b des zweiten Abschnittes 44b entfernt.

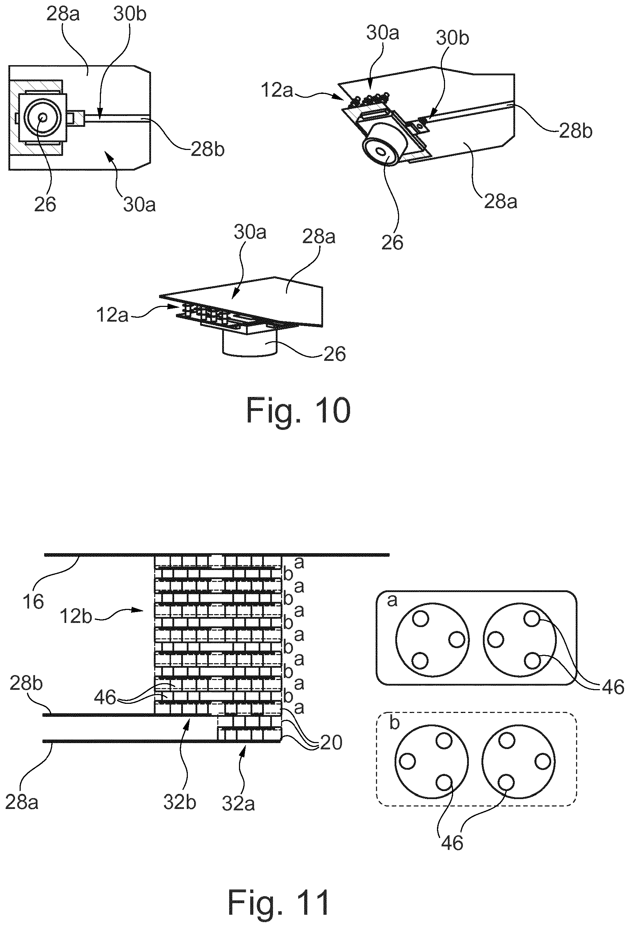

Fig. 10 zeigt drei perspektivische Darstellungen des Steckers 26, der externen Ankopplung 12a und des Symmetriergliedes 14 in der zweiten Ausführungsform, wobei das Symmetrierglied 14 nicht vollständig abgebildet ist. Das Symmetrierglied 14 in der zweiten Ausführungsform weist zwei Leiterbahnen 28a und 28b auf, die mit ihren jeweiligen Enden 30a und 30b über die externe Ankopplung 12a mit dem Stecker 26 kontaktiert sind. Die erste Leiterbahn 28a ist vier Substratlagen 20 vom Stecker 26 entfernt. Ihr Ende 30a ist rechteckig ausgestaltet und über die externe Ankopplung 12a mit dem Stecker 26 kontaktiert. Die zweite Leiterbahn 28b des Symmetriergliedes 14 ist zwei Substratlagen vom Stecker 26 entfernt. Ihr Ende 30b ist über die externe Ankopplung 12a mit dem Stecker 26 kontaktiert. Die erste und zweite Leiterbahn 28a und 28b sind zwei Substratlagen 20 voneinander entfernt.

Alle gezeigten Ankopplungen 12a, 12b, 12c stellen die elektrische Kontaktierung über eine Durchkontaktierung 46 her, welche schematisch in Fig. 11 gezeigt ist. Die Durchkontaktierungen 46 liegen in zwei Anordnungen (a, b) vor. Die Anordnungen a und b wechseln sich in jeder Substratlage 20 ab. So sind die Durchkontaktierungen 46 in den einzelnen Substratlagen versetzt zueinander angeordnet. Fig. 11 illustriert dies am Beispiel der internen Ankopplung 12b an den Sondenkopf 16. Der Aufbau der Durchkontaktierungen 46 trifft aber auf alle Ankopplungen 12a, 12b und 12c zu.

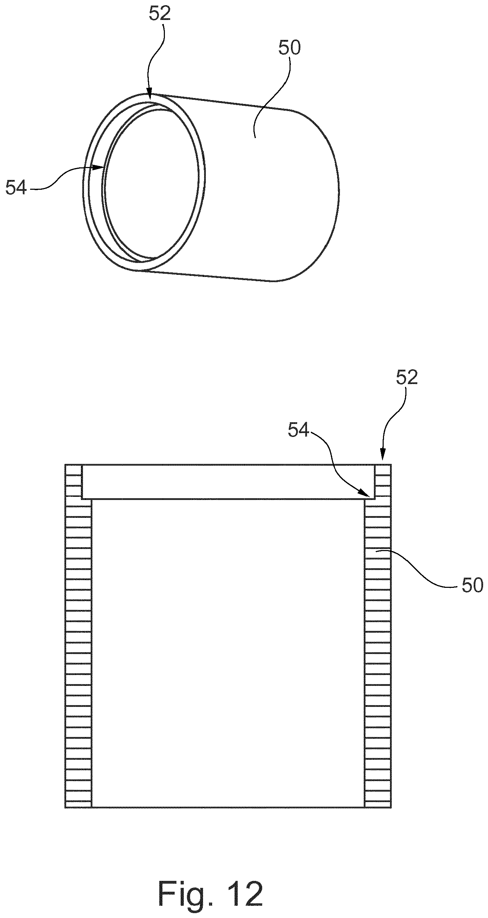

Fig. 12 zeigt eine perspektivische und eine schematische Darstellung eines Hohlzylinders 50. Der Hohlzylinder 50 weist in der Nähe einer Oberkante 52 an einer Innenwand einen Versatz auf, wobei der Substratzylinder auf einer Versatzkante 54 dieses Versatzes zu liegen kommt.

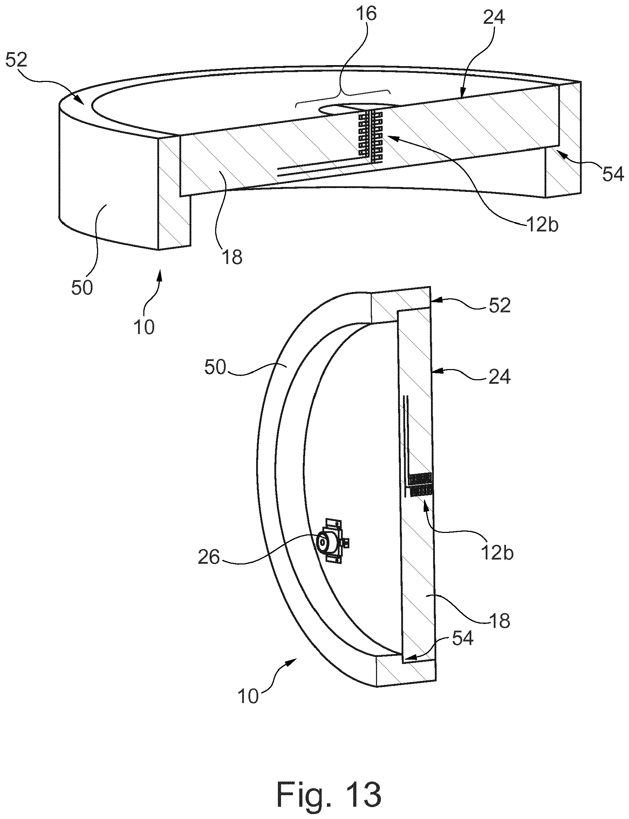

Fig. 13 zeigt zwei perspektivische Darstellungen der Sonde 10. Der Substratzylinder 18 ist so in den Hohlzylinder 50 eingepasst, dass die Oberkante 52 des Hohlzylinders 50 plan mit der Oberfläche 24 von einer Seite des Substratzylinders 18 abschließt. Dies ist die Seite des Substratzylinders 18, wo sich der Sondenkopf 16 befindet. Der Substratzylinder 18 liegt auf der Versatzkante 54 des Hohlzylinders 50 auf. Der Hohlzylinder 50 ist höher als der Substratzylinder und steht auf jener Seite des Substratzylinders 18, wo sich der Steckers 26 befindet, über. In der Fig. 13 ist ebenfalls noch die interne Ankopplung 12b dargestellt, die das Symmetrierglied 14 mit dem Sondenkopf 16 kontaktiert.

Die dieser Patentanmeldung zu Grunde liegende Erfindung entstand in einem Projekt, welches unter dem Förderkennzeichen 13N13212 vom BMBF gefördert wurde.

### Bezugszeichenliste

- 10: Sonde
- 12a: externe Ankopplung
- 12b: interne Ankopplung
- 12c: weitere Ankopplung
- 14: Symmetrierglied
- 16: Sondenkopf
- 18: Substratzylinder
- 20: Substratlage
- 22a,b: metallische Halbscheibe
- 24: Oberfläche des Substratzylinders 18
- 26: Stecker
- 28a: erste Leiterbahn, Masse-Lage
- 28b: zweite Leiterbahn, Signal-Lage
- 30a,b: Ende der Leiterbahnen
- 32a,b: anderes Ende der Leiterbahnen
- 34: gebogener Balun
- 36a,b,c,d: Abschnitte
- 38: Spirale
- 40: Ecken
- 42: gestapelt gefalteter Balun
- 44a,b: Abschnitte
- 46: Durchkontaktierung
- 48: Substratmaterial
- 50: Hohlzylinder
- 52: Oberkante
- 54: Versatzkante

## Patentansprüche

1. Sonde (10) zur Messung von Plasmaparametern mittels aktiver Plasma-Resonanzspektroskopie, wobei die Sonde (10) eine externe Ankopplung (12a), ein Symmetrierglied (14), eine interne Ankopplung (12b) und einen Sondenkopf (16) umfasst,
**dadurch gekennzeichnet, dass**
die Ankopplungen (12a, 12b), das Symmetrierglied (14) und der Sondenkopf (16) in einem elektrisch isolierenden Substratzylinder (18) integriert sind und der Substratzylinder (18) entlang seiner Rotationsachse einen schichtartigen Aufbau aus mehreren Substratlagen (20) aufweist.

2. Sonde (10) nach Anspruch 1,
**dadurch gekennzeichnet, dass**
die externe Ankopplung (12a), das Symmetrierglied (14), die interne Ankopplung (12b) und der Sondenkopf (16) entlang der Rotationsachse des Substratzylinders (18) in der genannten Reihenfolge in unterschiedlichen Substratlagen (20) angeordnet sind.

3. Sonde (10) nach einem der vorangehenden Ansprüche,
**dadurch gekennzeichnet, dass**
die Sonde (10) zwischen dem Sondenkopf (16) und dem Symmetrierglied (14) mindestens eine Substratlage (20) aufweist und der Sondenkopf (16) und das Symmetrierglied (14) über die interne Ankopplung (12b) miteinander kontaktiert sind.

4. Sonde (10) nach einem der vorangehenden Ansprüche,
**dadurch gekennzeichnet, dass**
die Sonde (10) einen Stecker (26) umfasst, wobei der Stecker (26) und das Symmetrierglied (14) über die externe Ankopplung (12a) miteinander kontaktiert sind.

5. Sonde (10) nach einem der vorangehenden Ansprüche,
**dadurch gekennzeichnet, dass**
das Symmetrierglied (14) zwei zueinander parallel verlaufende Leiterbahnen (28a, 28b) umfasst, wobei jeweils ein Ende (30a, 30b) der Leiterbahn (28a, 28b) mit der externen Ankopplung (12a) verbunden ist und das andere Ende (32a, 32b) der Leiterbahn (28a, 28b) mit der internen Ankopplung (12b), die Leiterbahnen (28a, 28b) durch mindestens eine Substratlage (20) voneinander getrennt sind, die erste Leiterbahn (28a) eine Masse-Lage ist, die zweite Leiterbahn (28b) eine Signal-Lage ist, die erste Leiterbahn (28a) eine sich verändernde Breite (B1, B2, B3) aufweist und die Leiterbahnen (28a, 28b) bezogen auf die Richtung der Rotationsachse des Substratzylinders (18) übereinander zu liegen kommen.

6. Sonde (10) nach einem der vorangehenden Ansprüche,
**dadurch gekennzeichnet, dass**
das Symmetrierglied (14) ein gebogener Balun (34) ist, der mindestens drei, bevorzugt vier unterschiedlich lange Abschnitte (36a, 36b, 36c, 36d) umfasst, wobei die Abschnitte (36a, 36b, 36c, 36d) in etwa rechtwinklig miteinander verbunden sind, so dass die Abschnitte (36a, 36b, 36c, 36d) die Form einer Spirale (38) bilden, und die Ecken (40) der Spirale (38) abgeschrägt sind.

7. Sonde (10) nach einem der Ansprüche 1 bis 5,
**dadurch gekennzeichnet, dass**
das Symmetrierglied (14) ein gestapelt gefalteter Balun (42) ist, der zwei zueinander parallel verlaufende Abschnitte (44a, 44b) umfasst, wobei die beiden Abschnitte (44a, 44b) durch mindestens eine Substratlage (20) voneinander getrennt sind und durch eine parallel zur Rotationsachse des Substratzylinders (18) verlaufende weitere Ankopplung (12c) miteinander kontaktiert sind.

8. Sonde (10) nach einem der vorangehenden Ansprüche,
**dadurch gekennzeichnet, dass**
die Ankopplungen (12a, 12b, 12c) Durchkontaktierungen (46) sind, die eine elektrische Verbindung durch die Substratlagen (20) hindurch ermöglichen.

9. Sonde (10) nach einem der vorangehenden Ansprüche,
**dadurch gekennzeichnet, dass**
der Substratzylinder (18) aus mindestens einem Substratmaterial (48), bevorzugt aus einer LTCC-Keramik, hergestellt ist, wobei das Substratmaterial (48) einen mehrlagigen Aufbau zulässt.

10. Sonde (10) nach einem der vorangehenden Ansprüche,
**dadurch gekennzeichnet, dass**
die äußerste Substratlage (20) auf der Seite des Substratzylinders (18), die sich näher beim Sondenkopf (16) befindet, aus einem anderen Substratmaterial (48) besteht als die anderen Substratlagen (20).

11. Sonde (10) nach einem der vorangehenden Ansprüche,
**dadurch gekennzeichnet, dass**
der Substratzylinder (18) in einen Hohlzylinder (50) aus Metall eingefasst ist und die Seite des Substratzylinders (18), die sich näher beim Sondenkopf (16) befindet, plan mit einer Oberkante (52) des Hohlzylinders (50) abschließt.

12. Sonde (10) nach einem der vorangehenden Ansprüche,
**dadurch gekennzeichnet, dass**
der Sondenkopf (16) zwei gegeneinander isolierte metallische Halbscheiben (22a, 22b) umfasst und durch mindestens eine Substratlage (20) von der Oberfläche (24) des Substratzylinders (18) getrennt ist.

13. Sonde (10) nach Anspruch 12,
**dadurch gekennzeichnet, dass** die Halbscheiben (22a, 22b) plan sind.

14. Sonde (10) nach Anspruch 12,
**dadurch gekennzeichnet, dass** die Halbscheiben (22a, 22b) auf einer Zylinderoder Kugeloberfläche gekrümmt sind.

## Claims

1. Probe (10) for measuring plasma parameters using active plasma resonance spectroscopy, wherein the probe (10) comprises an external coupling (12a), a balun (14), an internal coupling (12b), and a probe head (16),
**characterized in that**
the couplings (12a, 12b), the balun (14), and the probe head (16) are integrated in an electrically insulating substrate cylinder (18) and the substrate cylinder (18) has a layered structure of several substrate layers (20) along its axis of rotation.

2. Probe (10) according to claim 1,
**characterized in that**
the external coupling (12a), the balun (14), the internal coupling (12b) and the probe head (16) are arranged along the axis of rotation of the substrate cylinder (18) in said order in different substrate layers (20).

3. Probe (10) according to any one of the preceding claims,
**characterized in that**
the probe (10) comprises at least one substrate layer (20) between the probe head (16) and the balun (14), and the probe head (16) and the balun (14) are in contact with each other via the internal coupling (12b).

4. Probe (10) according to any one of the preceding claims,
**characterized in that**
the probe (10) comprises a plug (26), wherein the plug (26) and the balun (14) are in contact with each other via the external coupling (12a).

5. Probe (10) according to any one of the preceding claims,
**characterized in that**
the balun (14) comprises two conductive tracks (28a, 28b) extending parallel to each other, wherein one end (30a, 30b) of each conductive track (28a, 28b) is connected to the external coupling (12a) and the other end (32a, 32b) of the conductive track (28a, 28b) is connected to the internal coupling (12b), the conductive tracks (28a, 28b) are separated from one another by at least one substrate layer (20), the first conductive track (28a) is a ground layer, and the second conductive track (28b) is a signal layer, the first conductive track (28a) has a varying width (B1, B2, B3), and the conductive tracks (28a, 28b) come to lie one above the other with respect to the direction of the axis of rotation of the substrate cylinder (18).

6. Probe (10) according to any one of the preceding claims,
**characterized in that**
the balun (14) is a curved balun (34) comprising at least three, preferably four sections (36a, 36b, 36c, 36d) of different lengths, wherein the sections (36a, 36b, 36c, 36d) are connected to each other approximately at right angles so that the sections (36a, 36b, 36c, 36d) constitute the shape of a spiral (38) and the corners (40) of the spiral (38) are beveled.

7. Probe (10) according to any one of claims 1 to 5,
**characterized in that**
the balun (14) is a stacked folded balun (42) comprising two sections (44a, 44b) extending parallel to each other, wherein the two sections (44a, 44b) are separated from each other by at least one substrate layer (20) and are contacted with each other by a further coupling (12c) extending parallel to the axis of rotation of the substrate cylinder (18).

8. Probe (10) according to any one of the preceding claims,
**characterized in that**
the couplings (12a, 12b, 12c) are vias (46) allowing an electrical connection through the substrate layers (20).

9. Probe (10) according to any one of the preceding claims,
**characterized in that**
the substrate cylinder (18) is made of at least one substrate material (48), preferably an LTCC ceramic, wherein the substrate material (48) allows a multilayer structure.

10. Probe (10) according to any one of the preceding claims,
**characterized in that**
the outermost substrate layer (20) on the side of the substrate cylinder (18) that is closer to the probe head (16) consists of a substrate material (48) different from that of the other substrate layers (20).

11. Probe (10) according to any one of the preceding claims,
**characterized in that**
the substrate cylinder (18) is enclosed in a hollow cylinder (50) of metal and wherein the side of the substrate cylinder (18) that is closer to the probe head (16) is flush with an upper edge (52) of the hollow cylinder (50).

12. Probe (10) according to any one of the preceding claims,
**characterized in that**
the probe head (16) comprises two metallic half-disks (22a, 22b) insulated from each other and separated from the upper surface (24) of the substrate cylinder (18) by at least one substrate layer (20).

13. Probe (10) according to claim 12,
**characterized in that** the half-disks (22a, 22b) are planar.

14. Probe (10) according to claim 12,
**characterized in that** the half-disks (22a, 22b) are curved on a cylinder or sphere surface.

## Revendications

1. Sonde (10) de mesure de paramètres plasmatiques par spectroscopie de résonance plasmatique active, dans laquelle la sonde (10) comprend un couplage extérieur (12a), un symétriseur (14), un couplage intérieur (12b) et une tête de sonde (16),
**caractérisée en ce que**
les couplages (12a, 12b), le symétriseur (14), et la tête de sonde (16) sont intégrés dans un cylindre de substrat (18) électriquement isolant et le cylindre de substrat (18) comprend, le long de son axe de rotation, une structure en couches à plusieurs couches de substrat (20).

2. Sonde (10) selon la revendication 1,
**caractérisée en ce que**
le couplage extérieur (12a), le symétriseur (14), le couplage intérieur (12b) et la tête de sonde (16) sont agencés le long de l'axe de rotation du cylindre de substrat (18) dans ladite séquence dans de différentes couches de substrat (20).

3. Sonde (10) selon l'une quelconque des revendications précédentes,
**caractérisée en ce que**
la sonde (10) comprend au moins une couche de substrat (20) entre la tête de sonde (16) et le symétriseur (14), et la tête de sonde (16) et le symétriseur (14) sont en contact l'une avec l'autre par l'intermédiaire du couplage intérieur (12b) .

4. Sonde (10) selon l'une quelconque des revendications précédentes,
**caractérisée en ce que**
la sonde (10) comprend une prise (26), dans laquelle la prise (26) et le symétriseur (14) sont en contact l'une avec l'autre par l'intermédiaire du couplage extérieur (12a).

5. Sonde (10) selon l'une quelconque des revendications précédentes,
**caractérisée en ce que**
le symétriseur (14) comprend deux pistes conductrices (28a, 28b) s'étendant de façon parallèle l'une par rapport à l'autre, dans laquelle une extrémité (30a, 30b) de chaque piste conductrice (28a, 28b) est connectée au couplage extérieur (12a) et l'autre extrémité (30a, 30b) de chaque piste conductrice (28a, 28b) est connectée au couplage extérieur (12a), les pistes conductrices (28a, 28b) sont séparées l'une de l'autre par au moins une couche de substrat (20), la première piste conductrice (28a) est une couche de mesure, la seconde piste conductrice (28b) est une couche de signal, la première piste conductrice (28a) comprend une largeur (B1, B2, B3) variable, et les pistes conductrices (28a, 28b) se superposent l'une sur l'autre relativement à la direction de l'axe de rotation du cylindre de substrat (18).

6. Sonde (10) selon l'une quelconque des revendications précédentes,
**caractérisée en ce que**
le symétriseur (14) est un balun (34) courbé comprenant au moins trois, de préférence quatre sections de longueur différente (36a, 36b, 36c, 36d), dans laquelle les sections (36a, 36b, 36c, 36d) sont connectées les unes aux autres à peu près perpendiculairement, de sorte que les sections (36a, 36b, 36c, 36d) prennent la forme d'une spirale (38), et que les angles (40) de la spirale (38) sont biseautés.

7. Sonde (10) selon l'une quelconque des revendications 1 à 5,
**caractérisée en ce que**
le symétriseur (14) est un balun (42) plié, superposé, et comprenant deux sections (44a, 44b) s'étendant de façon parallèle l'une par rapport à l'autre, dans laquelle les deux sections (44a, 44b) sont séparées l'une de l'autre par au moins une couche de substrat (20) et sont en contact l'une avec l'autre par l'intermédiaire d'un couplage supplémentaire (12c) s'étendant de façon parallèle à l'axe de rotation du cylindre de substrat (18).

8. Sonde (10) selon l'une quelconque des revendications précédentes,
**caractérisée en ce que**
les couplages (12a, 12b, 12c) sont des connexions traversantes (46) permettant une connexion électrique à travers les couches de substrat (20).

9. Sonde (10) selon l'une quelconque des revendications précédentes,
**caractérisée en ce que**
le cylindre de substrat (18) est produit à partir d'au moins un matériau de substrat (48), de préférence d'une céramique LTCC, dans laquelle le matériau de substrat (48) permet une structure à plusieurs couches.

10. Sonde (10) selon l'une quelconque des revendications précédentes,
**caractérisée en ce que**
la couche de substrat (20) la plus externe du côté du cylindre de substrat (18), qui se trouve la plus proche de la tête de sonde (16), est constituée d'un matériau de substrat (48) autre que celui des autres couches de substrat (20).

11. Sonde (10) selon l'une quelconque des revendications précédentes,
**caractérisée en ce que**
le cylindre de substrat (18) est monté dans un cylindre creux (50) en métal et le côté du cylindre de substrat (18) le plus proche de la tête de sonde (16) se termine aligné avec un bord supérieur (52) du cylindre creux (50).

12. Sonde (10) selon l'une quelconque des revendications précédentes,
**caractérisée en ce que**
la tête de sonde (16) comprend deux demi-vitres (22a, 22b) métalliques isolées l'une de de l'autre et est séparée de la surface du cylindre de substrat (18) par l'intermédiaire d'au moins une couche de substrat (20).

13. Sonde (10) selon la revendication 12,
**caractérisée en ce que** les demi-vitres (22a, 22b) sont planes.

14. Sonde (10) selon la revendication 12,
**caractérisée en ce que** les demi-vitres (22a, 22b) sont courbées sur une surface cylindrique ou sphérique.
